# FASCICULE DE BREVET EUROPEEN

(11) **EP 1 488 510 B1**
(45) Date de publication et mention de la délivrance du brevet: **15.08.2007**
(21) Numéro de dépôt: 03717401.8
(22) Date de dépôt: 14.02.2003
(51) Int. Cl.: H03F 1/30, H03F 1/32

(54) **TRANSCONDUCTEUR A-AB**
TRANSKONDUKTORSCHALTUNG A-AB
A-AB TRANSCONDUCTOR

(30) Priorité: 15.02.2002 FR 0201939
(43) Date de publication de la demande: 22.12.2004
(73) Titulaire: STMicroelectronics SA, 92120 Montrouge (FR)
(72) Inventeur: BELOT, Didier, 38140 Rives (FR); PERSECHINI, Pascal, 38330 Saint Ismier (FR)
(74) Mandataire: de Beaumont, Michel
(86) Numéro de dépôt international: PCT/FR2003/000473
(87) Numéro de publication internationale: WO 2003/069774

(56) Documents cités:
- US-A- 5 633 610
- US-A1- 2001 048 347
- US-B1- 6 339 361
- PATENT ABSTRACTS OF JAPAN vol. 2002, no. 06, 4 juin 2002 (2002-06-04) & JP 2002 050933 A (HITACHI KOKUSAI ELECTRIC INC), 15 février 2002 (2002-02-15)

## Description

La présente invention concerne de façon générale le domaine des transconducteurs. Plus particulièrement, la présente invention concerne les transconducteurs susceptibles d'être utilisés dans des dispositifs multimode, c'est-à-dire destinés à traiter des signaux présentant des caractéristiques de fréquence différentes.

Le document US-A-6 339 361 divulgue en exemple de transconducteur.

On considère plus particulièrement dans la présente description des transconducteurs non-linéaires dits de classe A et des transconducteurs linéaires dits de classe AB.

Les transconducteurs de classe A ou de classe AB sont utilisés pour réaliser de nombreuses fonctions telles que, notamment, des amplifications ou des mélanges de signaux. Par exemple, des transconducteurs sont utilisés dans des chaînes de transmission, d'émission ou de réception de signaux pour réaliser, notamment des amplificateurs de réception dits à faible bruit (LNA), des amplificateurs d'émission dits de puissance (PA) ou encore des mélangeurs.

Le type - classe A ou classe AB- du transconducteur utilisé pour réaliser telle ou telle fonction dépend de l'application. Considérons par exemple le cas des chaînes de transmission dans le domaine de la radiotéléphonie ou téléphonie mobile. Dans ce domaine, il existe différentes normes caractérisées notamment par des plages de fréquences différentes, parmi lesquelles les normes UMTS ou WDCMA d'une fréquence de l'ordre de 2,16 Hz, la norme GSM d'une fréquence de 900 MHz ou la norme DCS d'une fréquence de 1,8 GHz.

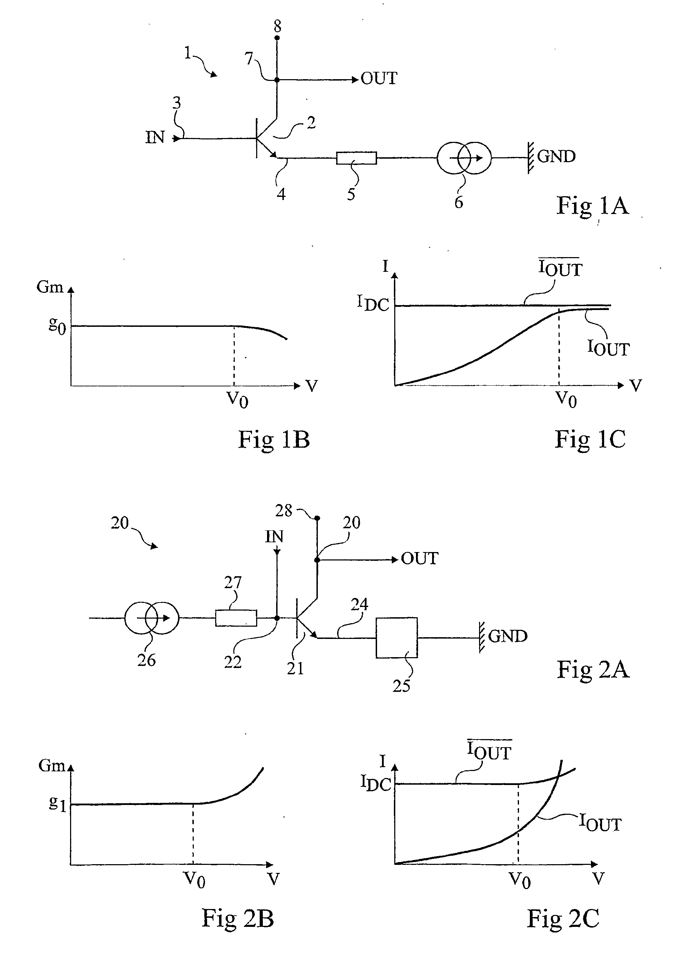

La figure 1A illustre, de façon schématique, la structure d'un transconducteur 1. Un tel transconducteur 1 comprend essentiellement un transistor bipolaire 2 de type NPN. La base 3 du transistor 2 constitue une première borne d'entrée/sortie du transconducteur. La base 2 reçoit un signal d'entrée IN, par exemple en téléphonie mobile un signal radiofréquence. L'émetteur 4 du transistor 2 est relié à une ligne de référence basse de tension ou masse GND, par l'intermédiaire d'une connexion en série d'une impédance 5 et d'une source de courant continu constant 6. Le collecteur 7 du transistor 2 constitue une seconde borne d'entrée/sortie du transconducteur et fournit le signal de sortie OUT du transconducteur 1. Le collecteur 7 est connecté à un quelconque dispositif, illustré par une borne d'entrée/sortie 8, fournissant un signal à mélanger au signal d'entrée IN. Par exemple, le dispositif 8 fournit un signal permettant de commuter le signal d'entrée IN, ou un signal porteur destiné à être modulé par le signal d'entrée IN. Le dispositif 8 n'est pas forcément unique. Il peut être un étage intermédiaire d'un mélangeur de plusieurs signaux, destiné à acquérir un des signaux à mélanger.

Les figures 1B et 1C illustrent respectivement des caractéristiques de gain de transconductance G et de courant I en fonction du niveau de tension d'entrée V dans le transconducteur de la figure 1A. Le gain de transconductance G, qui est proportionnel à la valeur du courant de polarisation du transistor 2 est une constante g₀ pour de faibles niveaux de la tension base-émetteur V aux bornes du transistor 2. Au-delà d'un certain seuil V₀, le gain G décroît. En deçà du seuil V₀, le courant dynamique de sortie I_{OUT} est alors, comme l'illustre la figure 1C, proportionnel à la tension base-émetteur V et limité par la valeur I_{DC} de la source de courant continu 6. Au-delà du seuil V₀, le comportement du transconducteur classe A est mal défini. Les signaux d'entrée sont donc limités à ceux pour lesquels la tension d'entrée est inférieure à V₀.

La figure 2A illustre schématiquement la structure d'un transconducteur 20 de classe AB. Les figures 2B et 2C, homologues des figures 1B et 1C, illustrent les caractéristiques gain et courant de sortie en fonction de la tension d'entrée du transconducteur 20.

Le transconducteur 20 comporte essentiellement un transistor bipolaire 21 de type NPN, dont la base 22 constitue une première borne d'entrée/sortie, destinée à recevoir un signal IN, par exemple radiofréquence, dont le collecteur 23 constitue une borne de sortie d'un courant OUT et dont l'émetteur 24 est dégénéré, c'est-à-dire est relié à une alimentation de référence GND par une impédance 25. En outre, la base 22 est reliée à une source de polarisation en courant 26 par une résistance 27. Comme précédemment pour le transconducteur 1 classe A de la figure 1A, le collecteur 23 peut être relié à un dispositif 28 d'entrée d'un signal à mélanger ou d'une consigne d'amplification ou d'un signal porteur ou autre.

Le transconducteur 20 présente une caractéristique exponentielle de gain G en fonction de la tension base-émetteur d'entrée V, illustrée en figure 2B. Ceci permet, comme l'illustre la figure 2C, d'obtenir une composante statique (ou courant moyen) I_{OUT} du courant du signal de sortie qui varie en fonction du signal d'entrée. La composante dynamique du courant du signal de sortie Iout n'est alors plus limité par le signal de polarisation, mais suit, voire dépasse, le courant moyen.

Dans l'exemple d'application à la téléphonie, pour permettre à un utilisateur de conserver un dispositif donné lors d'un changement de norme, on doit prévoir pour chaque fonction un mélangeur par gamme de fréquences. Une telle solution est contradictoire avec la miniaturisation des dispositifs portables.

On pourrait alors penser utiliser des mélangeurs de classe A constitués de transconducteurs similaires au transconducteur 1 de la figure 1A que l'on forcerait à avoir un comportement linéaire en imposant un courant constant (source 6) suffisamment élevé pour que le transistor 2 fonctionne en régime linéaire. Une telle solution présenterait de nombreux inconvénients. Notamment, de tels mélangeurs présenteraient une linéarité relativement faible par rapport aux mélangeurs classe AB constitués de transconducteurs de classe AB. En outre, ceci serait obtenu au prix d'une consommation élevée. Une telle consommation existerait alors également pour des petits signaux bien qu'elle ne serait pas nécessaire. Ceci serait particulièrement désavantageux du fait du grand nombre de transconducteurs utilisés dans un dispositif d'émission-réception multimode. Les alimentations nécessaires deviendraient alors encombrantes et imposeraient au mieux de fréquentes recharges, ce qui est incompatible avec le caractère mobile du dispositif. De plus, la consommation élevée, inutile dans le cas des petits signaux, imposerait des contraintes supplémentaires de dissipation sous forme d'énergie thermique.

La présente invention vise à proposer un transconducteur multimode.

La présente invention vise à proposer un tel transconducteur qui se comporte, en fonction du niveau du signal d'entrée, en classe A ou en classe AB.

La présente invention vise à proposer un tel transconducteur qui ajuste automatiquement son niveau de consommation au niveau nécessaire à son fonctionnement.

Pour atteindre ces objets et d'autres, la présente invention prévoit un transconducteur comportant des moyens pour sélectionner automatiquement un fonctionnement non-linéaire de classe A ou un fonctionnement linéaire de classe AB à partir d'un signal d'entrée à traiter, et pour ajuster automatiquement le courant prélevé sur une alimentation à un niveau nécessaire à son fonctionnement.

Selon un mode de réalisation de la présente invention, le transconducteur comprend au moins deux transistors bipolaires dont les bases communes définissent une première borne d'entrée/sortie du transconducteur ;
dont les collecteurs interconnectés définissent une seconde borne d'entrée/sortie du transconducteur ;
dont les émetteurs sont reliés individuellement à une ligne de référence basse de tension par une impédance respective ; et
dont les bases sont reliées à une même source de courant continu.

Selon un mode de réalisation de la présente invention, les impédances de chaque liaison individuelle des émetteurs des deux transistors bipolaires à la ligne de référence basse de tension (GND) sont uniquement résistives.

Selon un mode de réalisation de la présente invention, les bases sont reliées à la source de courant continu par une résistance d'isolement.

Selon un mode de réalisation de la présente invention, les rapports de la résistance d'isolement sur la résistance de la liaison individuelle des émetteurs à la ligne de référence sont différents.

Selon un mode de réalisation de la présente invention, les deux transistors bipolaires sont de dimensions différentes, et l'impédance de la liaison résistive individuelle de chacun de leurs émetteurs à la ligne de référence de tension est effectuée par une résistance respective.

Selon un mode de réalisation de la présente invention, la source de courant continu est constituée par la connexion, entre une ligne d'alimentation haute et la ligne de référence de tension basse, d'une source de courant continu et d'un premier transistor bipolaire d'un type donné, le point d'interconnexion de la source de courant et du premier transistor étant relié à la base d'un deuxième transistor bipolaire de même type que le premier transistor, dont une borne de collecteur/émetteur est reliée à la ligne d'alimentation haute et une borne d'émetteur/collecteur est reliée à la base du premier transistor et constitue la sortie de la source de courant.

Selon un mode de réalisation de la présente invention, une résistance est intercalée entre la base du premier transistor bipolaire et la borne d'émetteur/collecteur du deuxième transistor bipolaire constituant la sortie de la source de courant continu.

La présente invention prévoit également un étage d'entrée/sortie d'un mélangeur ou d'un amplificateur de puissance ou d'un amplificateur faible bruit, constitué d'un transconducteur selon l'un quelconque des modes de réalisation qui précédent.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A décrite précédemment représente le schéma de principe d'un transconducteur classique de classe A ;
les figures 1B et 1C décrites précédemment illustrent des caractéristiques du transconducteur de la figure 1A ;
la figure 2A décrite précédemment représente le schéma de principe d'un transconducteur classique de classe AB ;
les figures 2B et 2C décrites précédemment illustrent des caractéristiques du transconducteur de la figure 2A ;
La figure 3A illustre schématiquement la structure d'un transconducteur selon la présente invention ;
la figure 3B illustre une caractéristique de gain en fonction d'une tension d'entrée du transconducteur de la figure 3A ; et
la figure 3C illustre une caractéristique de courant de sortie en fonction de la tension d'entrée du transconducteur de la figure 3A.

Seuls les éléments nécessaires à la compréhension de la présente invention ont été représentés et seront décrits par la suite. En particulier, les circuits amont et avals d'un transconducteur selon l'invention n'ont pas été détaillés et ne font pas l'objet de la présente invention. Celle-ci s'applique quels que soient les signaux d'entrée et de sortie. De plus, de mêmes éléments ont été désignés par les mêmes références aux différentes figures. Par ailleurs, les caractéristiques des figures 1B, 1C, 2B, 2C, 3B et 3C ne sont pas tracées à l'échelle.

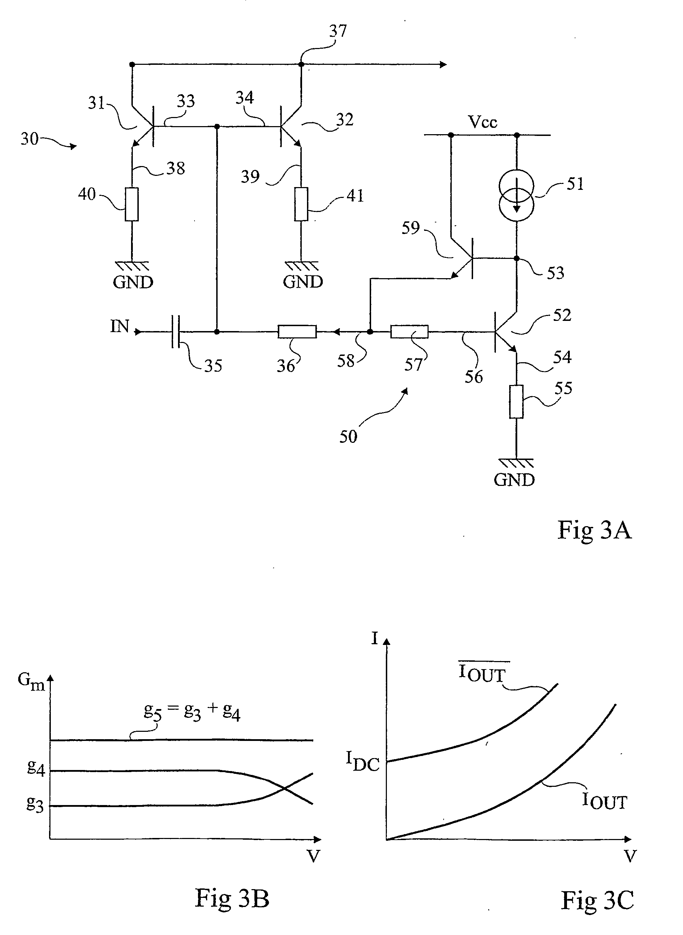

La figure 3A illustre schématiquement la structure d'un transconducteur 30 de classe AB selon la présente invention.

Le transconducteur 30 comprend au moins deux transistors bipolaires 31, 32 de même type, par exemple NPN. Les bases 33 et 34 des transistors 31 et 32 sont interconnectées en un point commun. La base commune 33-34 constitue une borne d'entrée/sortie destinée, par exemple, à recevoir un signal d'entrée IN. Un signal d'entrée IN de type radiofréquence est découplé par un condensateur 35. La base commune 33-34 est en outre reliée à une source de courant continu 50 par une résistance d'isolement 36. Les collecteurs des transistors 31 et 32 sont interconnectés et constituent une borne de sortie/entrée 37. Les émetteurs 38 et 39 des transistors 31 et 32 sont reliés individuellement à une ligne de référence en tension GND par une liaison résistive respective. La résistance de la liaison est représentée en figure 3A en intercalant une résistance 40, 41 entre la ligne de référence GND et l'émetteur 38, 39 du transistor 31, 32 respectivement.

La figure 3A illustre un mode de réalisation possible de la source de courant continu 50. La source 50 comporte, intercalés en série entre une ligne d'alimentation en tension haute Vcc et la ligne de référence GND, une source de courant 51 (par exemple, un circuit à base de transistors MOS) et un transistor bipolaire 52 de type NPN. Le transistor 52 est relié à la source 51 par son collecteur 53 et à la ligne de référence GND par son émetteur 54. Une résistance 55 est intercalée entre l'émetteur 54 et la référence GND. La base du transistor 52 est reliée à une première borne 56 d'une résistance d'isolement 57. Une deuxième borne 58 de la résistance d'isolement 57 est reliée aux bases 33, 34 par la résistance d'isolement respective 36. La source 50 comporte en outre un transistor 59 de type NPN dont la base est reliée au collecteur 53, donc également à la source 51, dont l'émetteur est relié à la deuxième borne 58 de la résistance d'isolement 57 et dont le collecteur est relié à l'alimentation haute Vcc.

Les valeurs des différentes résistances d'isolement 36 et des liaisons résistives 40 et 41 sont choisies en fonction des contraintes suivantes.

La résistance d'isolement 36 doit présenter une valeur suffisamment élevée pour garantir l'isolement de la source de courant continu 50 par rapport aux variations du signal d'entrée IN. En effet, si la résistance d'isolement 36 est trop faible, les bruits éventuels de la source 50 atteindront la base commune 33-34. La résistance d'isolement 36 doit toutefois être suffisamment faible pour permettre le passage du courant continu nécessaire à la polarisation des transistors 31 et 32.

Le choix des résistances 40 et 41 des liaisons résistives est effectué en fonction du choix de la valeur de la résistance d'isolement 36 de la façon suivante. D'une part, les deux transistors 31 et 32 doivent présenter des transconductances différentes, c'est-à-dire différents produits du courant de polarisation par la résistance de dégénérescence. La détermination des valeurs de transconductance à utiliser est effectuée, par exemple, par des développements dits de Volterra.

Selon un mode de réalisation de la présente invention, tous les transistors sont identiques.

Le comportement du transconducteur 30 sera décrit ci-après en relation avec les figures 3B et 3C. La figure 3B, qui est à comparer avec les figures 1B et 2B, illustre le gain G de l'étage en fonction de la tension d'entrée/sortie V. La figure 3C, qui est à comparer avec les figures 1C et 2C, illustre les variations du courant de sortie du transconducteur I_{OUT} en fonction de la même tension d'entrée V. La tension d'entrée V considérée est la tension base-émetteur appliquée aux bornes des transistors en parallèle 31 et 32. Le gain du transconducteur demeure constant à une valeur g₅. Toutefois, chaque transistor 31, 32 présente un gain propre g₃, g₄ caractéristique d'un étage de classe AB. Notamment, au-delà d'un certain seuil V₀, chaque gain g₃, g₄ varie. Une réalisation à transconductances multiples selon la présente invention permet d'obtenir des variations inverses et de mêmes amplitudes. Par exemple, le gain g₃ tend à croître à partir du seuil V₀, alors que le gain g₄ tend à décroître.

Pour des petits signaux d'entrée, le transconducteur présente alors un comportement de type classe A. Le signal de courant statique de sortie *I_{OUT}* reste constant sans tenir compte des variations du signal d'entrée. Au-delà d'une certaine puissance d'entrée, le transconducteur adopte un comportement de classe AB, quelle que soit la puissance d'entrée, c'est-à-dire la tension V. Le signal de sortie I_{OUT} varie de façon exponentielle en fonction du signal d'entrée. En parallèle, le niveau du courant (non représenté) prélevé par la source 50 sur l'alimentation GND-Vcc demeure constant à une valeur minimale I_{DC} que le transconducteur fonctionne en classe A ou en classe AB. Le courant statique *I_{OUT}* du transconducteur, dont la valeur minimale est fixée par la source de polarisation 50, varie de façon exponentielle en fonction du signal d'entrée dès que le transconducteur passe en classe de fonctionnement AB.

La présente invention fournit donc avantageusement un transconducteur susceptible de commuter automatiquement d'un fonctionnement en classe A à un fonctionnement en classe AB et inversement en fonction du signal d'entrée.

Un tel étage est donc avantageusement utilisable comme étage d'entrée d'un mélangeur ou d'un amplificateur faible bruit ou de puissance quelle que soit la norme du signal d'entrée. On peut alors utiliser un unique étage d'entrée dans des applications multimode. Il n'est plus nécessaire de fabriquer des étages dédiés spécifiques à un mode de fonctionnement, c'est-à-dire de prévoir autant de filières de fabrication spécifiques que de modes.

En outre, la consommation est avantageusement automatiquement ajustée et limitée aux besoins du transconducteur en fonction du mode de fonctionnement.

De plus, lors d'un fonctionnement en classe AB, le transconducteur multimode selon la présente invention présente avantageusement une linéarité supérieure aux transconducteurs de classe AB connus. En effet, l'association de transconductances multiples permet d'obtenir des produits d'intermodulation plus faibles que les transconducteurs de classe AB connus.

Bien entendu, la présente invention est susceptible de diverses variantes et modifications qui apparaîtront à l'homme de l'art. En particulier, la présente invention a été décrite dans le cas d'un transconducteur équivalent comportant deux transconductances distinctes. Toutefois, il est possible d'accroître le nombre de transistors.

## Revendications

1. Transconducteur, **caractérisé en ce qu'**il comporte des moyens pour sélectionner automatiquement un fonctionnement non-linéaire de classe A ou un fonctionnement linéaire de classe AB à partir d'un signal d'entrée à traiter, et pour ajuster automatiquement le courant prélevé sur une alimentation à un niveau nécessaire à son fonctionnement, lesdits moyens comprenant au moins deux transistors bipolaires (31, 32) dont les bases communes (33, 34) définissent une première borne d'entrée/sortie du transconducteur ;
dont les collecteurs interconnectés définissent une seconde borne d'entrée/sortie (37) du transconducteur ;
dont les émetteurs (38, 39) sont reliés individuellement à une ligne de référence basse de tension (GND) par une impédance respective (40, 41) ; et
dont les bases sont reliées à une même source de courant continu (50).

2. Transconducteur selon la revendication 1, **caractérisé en ce que** les impédances de chaque liaison individuelle des émetteurs (38, 39) des deux transistors bipolaires (31, 32) à la ligne de référence basse de tension (GND) sont uniquement résistives.

3. Transconducteur selon la revendication 1 ou 2, **caractérisé en ce que** les bases sont reliées à la source de courant continu (50) par une résistance d'isolement (36).

4. Transconducteur selon les revendications 2 et 3, **caractérisé en ce que** les rapports de la résistance d'isolement (36) sur la résistance de la liaison individuelle (40, 41) des émetteurs (38, 39) à la ligne de référence (GND) sont différents.

5. Transconducteur selon la revendication 3 ou 4, **caractérisé en ce que** les deux transistors bipolaires (31, 32) sont de dimensions différentes, et **en ce que** l'impédance de la liaison résistive individuelle de chacun de leurs émetteurs (38, 39) à la ligne de référence de tension (GND) est effectuée par une résistance respective (40, 41).

6. Transconducteur selon l'une quelconque des revendications 1 à 5, **caractérisé en ce que** la source de courant continu (50) est constituée par la connexion, entre une ligne d'alimentation haute (Vcc) et la ligne de référence de tension basse (GND), d'une source de courant continu (51) et d'un premier transistor bipolaire d'un type donné (52), le point d'interconnexion (53) de la source de courant et du premier transistor étant relié à la base d'un deuxième transistor bipolaire (59) de même type que le premier transistor, dont une borne de collecteur/émetteur est reliée à la ligne d'alimentation haute (Vcc) et une borne d'émetteur/collecteur est reliée à la base (56) du premier transistor et constitue la sortie (58) de la source de courant.

7. Transconducteur selon la revendication 6, **caractérisé en ce qu'**une résistance (57) est intercalée entre la base (56) du premier transistor bipolaire (52) et la borne d'émetteur/collecteur du deuxième transistor bipolaire (59) constituant la sortie (58) de la source de courant continu (50).

8. Etage d'entrée/sortie d'un mélangeur ou d'un amplificateur de puissance ou d'un amplificateur faible bruit, **caractérisé en ce qu'**il est constitué d'un transconducteur selon l'une quelconque des revendications 1 à 7.

## Claims

1. A transconductor, **characterized in that** it includes means for automatically selecting a non-linear class A operation or a linear class AB operation based on an input signal to be processed, and for automatically adjusting the current from a power supply to a level necessary to its operation, said means including at least two bipolar transistors (31, 32), the common bases (33, 34) of which define a first input/output terminal of the transconductor;
the interconnected collectors of which define a second input/output terminal (37) of the transconductor;
the emitters (38, 39) of which are individually connected to a low voltage reference line (GND) by a respective impedance (40, 41); and
the bases of which are connected to a same D.C. current source (50).

2. The transconductor of claim 1, **characterized in that** the impedances of each individual connection of the emitters (38, 39) of the two bipolar transistors (31, 32) to the low voltage reference line (GND) are only resistive.

3. The transconductor of claim 1 or 2, **characterized in that** the bases are connected to the D.C. current source (50) by an isolating resistor (36).

4. The transconductor of claims 2 and 3, **characterized in that** the ratios of the isolating resistance (36) to the resistance of the individual connection (40, 41) of the emitters (38, 39) to the reference line (GND) are different.

5. The transconductor of claim 3 or 4, **characterized in that** the two bipolar transistors (31, 32) are of different sizes, and wherein the impedance of the individual resistive connection of each of their emitters (38, 39) to the voltage reference line (GND) is implemented by a respective resistor (40, 41) .

6. The transconductor of any of claims 1 to 5, wherein the D.C. current source (50) is formed by the connection, between a high supply line (Vcc) and the low voltage reference line (GND), of a D.C. current source (51) and of a first bipolar transistor of a given type (52), the junction (53) of the current source and of the first transistor being connected to the base of a second bipolar transistor (59) of the same type as the first transistor, a collector/emitter terminal of which is connected to the high supply line (Vcc) and an emitter/collector terminal of which is connected to the base (56) of the first transistor and forms the current source output (58).

7. The transconductor of claim 6, wherein a resistor (57) is interposed between the base (56) of the first bipolar transistor (52) and the emitter/collector terminal of the second bipolar transistor (59) forming the output (58) of the D.C. current source (50).

8. Input/output stage of a mixer or of a power amplifier or of a low-noise amplifier, formed of a transconductor according to any of claims 1 to 7.

## Patentansprüche

1. Ein Transkonduktor **dadurch gekennzeichnet, dass** er Mittel aufweist zum automatischen Auswählen eines nicht-linearen Klasse-A-Betriebs oder eines linearen Klasse-AB-Betriebs, basierend auf einem zu verarbeitenden Eingangssignal, und zum automatischen Einstellen bzw. Anpassen des Stroms von einer Energieversorgung auf ein Niveau, das für seinen Betrieb notwendig ist, wobei die Mittel mindestens zwei Bipolartransistoren (31, 32) aufweisen, deren gemeinsame Basen (33, 34) einen ersten Eingangs-/-Ausgangsanschluss des Transkonduktors definieren;
deren zusammengeschaltete Kollektoren einen zweiten Eingangs-/-Ausgangsanschluss (37) des Transkonduktors definieren;
deren Emitter (38, 39) individuell mit einer Niederspannungsreferenzleitung (GND) mit einer entsprechenden Impedanz (40, 41) individuell verbunden sind; und
deren Basen mit einer gleichen Gleichstrom- bzw. DC-Stromquelle (50) verbunden sind.

2. Transkonduktor nach Anspruch 1, **dadurch gekennzeichnet, dass** die Impedanzen von jeder individuellen Verbindung der Emitter (38, 39) der zwei Bipolartransistoren (31, 32) mit der Niederspannungsreferenzleitung (GND) nur resistiv sind.

3. Transkonduktor nach Anspruch 1 oder 2, **dadurch gekennzeichnet, dass** die Basen mit der DC-Stromquelle (50) durch einen isolierenden Widerstand (36) verbunden sind.

4. Transkonduktor nach den Ansprüchen 2 und 3, **dadurch gekennzeichnet, dass** die Verhältnisse von dem isolierenden Widerstand (36) zu dem Widerstand der individuellen Verbindung (40, 41) von den Emittern (38, 39) zu der Referenzleitung (GND) unterschiedlich sind.

5. Transkonduktor nach Anspruch 3 oder 4, **dadurch gekennzeichnet, dass** die zwei Bipolartransistoren (31, 32) verschiedene Größen haben, und wobei die Impedanz von der individuellen resistiven Verbindung bzw. Widerstandsverbindung von jedem von ihren Emittern (38, 39) zu der Spannungsreferenzleitung (GND) durch einen entsprechenden Widerstand (40, 41) implementiert ist.

6. Transkonduktor nach irgendeinem der Ansprüche 1 bis 5, wobei die DC-Stromquelle (50) durch die Verbindung gebildet ist, und zwar zwischen einer Hochversorgungsleitung (Vcc) und der Niederspannungsreferenzleitung (GND) von einer DC-Stromquelle (51) und von einem ersten Bipolartransistor mit einem vorgegebenen Typ (52), wobei die Verbindung bzw. die Abzweigung (53) von der Stromquelle und dem ersten Transistor mit der Basis eines zweiten Bipolartransistors (59) von dem gleichen Typ wie der erste Transistor verbunden ist, wobei ein Kollektor-/Emitteranschluss von ihm mit der Hochversorgungsleitung (Vcc) verbunden ist und ein Emitter-/-Kollektoranschluss von ihm mit der Basis (56) des ersten Transistors verbunden ist und den Stromquellenausgang (58) bildet.

7. Transkonduktor nach Anspruch 6, wobei ein Widerstand (57) angeordnet ist zwischen der Basis (56) des ersten Bipolartransistors (52) und dem Emitter/Kollektoranschluss des zweiten Bipolartransistors (59), um den Ausgang (58) der DC-Stromquelle (50) zu bilden.

8. Eingangs-/Ausgangsstufe eines Mischers oder eines Leistungsverstärkers oder eines rauscharmen Verstärkers gebildet aus einem Transkonduktor gemäß irgendeinem der Ansprüche 1 bis 7.
